# FASCICULE DE BREVET EUROPEEN

(11) **EP 1 439 971 B1**
(45) Date de publication et mention de la délivrance du brevet: **25.05.2005**
(21) Numéro de dépôt: 02795332.2
(22) Date de dépôt: 18.10.2002
(51) Int. Cl.: B60H 1/00, H05K 7/20

(54) **GROUPE MOTO-VENTILATEUR, NOTAMMENT POUR INSTALLATION DE CHAUFFAGE ET/OU DE CLIMATISATION DE VEHICULE AUTOMOBILE**
MOTOR-GEBLÄSE, INBESONDERE FÜR EINE HEIZUNGS- UND/ODER KLIMAANLAGE EINES FAHRZEUGES
MOTOR FAN SYSTEM WHICH IS INTENDED, IN PARTICULAR, FOR A MOTOR VEHICLE HEATING AND/OR AIR-CONDITIONING SYSTEM

(30) Priorité: 02.11.2001 FR 0114240
(43) Date de publication de la demande: 28.07.2004
(73) Titulaire: VALEO SYSTEMES THERMIQUES, 78320 Le Mesnil Saint-Denis (FR)
(72) Inventeur: KONG-A-SIOU, Dung, F-94600 Choisy le Roi (FR); GATINOIS, Jean, F-78760 Jouars Pont Chartrain (FR)
(86) Numéro de dépôt international: PCT/FR2002/003585
(87) Numéro de publication internationale: WO 2003/037664

(56) Documents cités:
- FR-A- 2 654 156
- FR-A- 2 676 610
- FR-A- 2 730 894
- FR-A- 2 798 988

## Description

### Arrière-plan de l'invention

L'invention concerne un groupe moto-ventilateur. Le domaine d'application est notamment celui des installations de chauffage et/ou de climatisation, en particulier pour les véhicules automobiles.

Pour de telles applications, il est connu de réaliser un groupe moto-ventilateur du type comportant un boîtier de volute, une turbine logée dans le boîtier de volute pour engendrer un flux d'air dans celle-ci, un moteur d'entraînement de la turbine, un support pour le moteur formant également capot d'obturation de la volute d'un côté de celle-ci, et un module de commande du moteur permettant de faire varier la vitesse du moteur selon les besoins.

Le module de commande de vitesse du moteur de groupe moto-ventilateur comporte de façon connue, une carte de circuit imprimé sur laquelle sont disposés des composants électroniques reliés entre eux par des pistes électriques.

Un problème à résoudre est l'évacuation de la chaleur générée par les pertes par effet joule des composants électroniques. En effet, une absence de refroidissement des composants électroniques risque de diminuer leur fiabilité et leurs performances ou même de les détruire.

Aussi, il est connu (voir par exemple FR-A-2798988) à cet effet d'associer au module de commande un radiateur pour dissiper la chaleur engendrée par ces composants électroniques couplés thermiquement aux composants électroniques par rayonnement (de par la surface du radiateur) et/ou par convection, forcée ou non.

Du fait de la grande quantité de chaleur à évacuer dans un module de commande d'un moteur d'un groupe moto-ventilateur, il est nécessaire de forcer la convection de chaleur du radiateur. Il a été en particulier proposé d'exposer le radiateur au flux d'air engendré dans le boîtier de volute. Mais, du fait de sa taille importante, le radiateur est installé en sortie du boîtier de volute, ce qui impose un éloignement entre ces composants du module de commande en contact thermique avec le radiateur et le moteur à commander source de rayonnements électromagnétiques indésirables.

De plus, la présence d'ailettes de radiateur qui pénètrent sur une distance relativement importante dans le flux d'air issu de la volute engendre des perturbations d'écoulement et du bruit.

### Objet et résumé de l'invention

L'invention a pour but de réaliser un couplage thermique optimal entre les composants électroniques à refroidir et le radiateur permettant une meilleure dissipation de la chaleur et une réduction de l'encombrement du radiateur rendant possible son implantation au plus près du moteur.

Ce but est atteint grâce à un groupe moto-ventilateur du type défini en tête de la présente description et dans lequel le module de commande comporte un radiateur en une seule pièce qui s'étend sur toute la surface inférieure de la carte de circuit imprimé et qui présente des premières zones de contact en contact thermique direct avec une pluralité de composants électroniques et des secondes zones de contact en contact thermique avec des zones équipotentielles sur la surface inférieure de la carte de circuit imprimé.

Avantageusement, les pistes électriques transportant le courant destiné à alimenter le moteur présentent une résistance totale inférieure à environ 2 mΩ.

Les premières zones de contact du radiateur présentent au moins une remontée de matière traversant la carte du circuit imprimé pour épouser la forme d'au moins un composant électronique.

Les premières zones de contact présentent au moins une zone de contact épousant la forme d'au moins un composant électronique connecté à la carte de circuit imprimé et situé à l'extérieur d'un bord de ladite carte.

Ainsi, une pince est destinée à assurer une pression de contact dudit composant électronique situé à l'extérieur de la carte de circuit imprimé contre le radiateur.

Un capot est fixé sur le radiateur de façon à assurer une pression de contact de la carte de circuit imprimé contre le radiateur.

Le capot peut être en matière synthétique.

De préférence, le radiateur est en aluminium.

Avantageusement, une vis unique est destinée à fixer la carte de circuit imprimé sur le radiateur.

L'invention a aussi pour objet une installation de chauffage et/ou climatisation pour véhicule automobile, comportant un groupe moto-ventilateur tel que défini ci-dessus.

### Brève description des dessins

L'invention sera mieux comprise à la lecture de la description faite ci-après, à titre indicatif mais non limitatif, en référence aux dessins annexés, sur lesquels :
- la figure 1 est une vue très schématique d'une installation de chauffage et climatisation pour véhicule automobile,
- la figure 2 est une vue en élévation d'un groupe moto-ventilateur intégrant un module de commande selon l'invention,
- la figure 3 est une vue en perspective d'un exemple de réalisation d'un module de commande selon l'invention,
- la figure 4 est une vue éclatée du module de commande de la figure 3,
- la figure 5 est une vue de la carte de circuit imprimé du module de commande de la figure 3.

### Description détaillée de modes de réalisation de l'invention

Un mode de réalisation de l'invention sera décrit ci-après dans le cadre de l'application à une installation de chauffage et/ou de climatisation de véhicule automobile. Un groupe moto-ventilateur selon l'invention est toutefois utilisable pour d'autres applications requérant la génération d'un flux d'air ou de tout autre gaz.

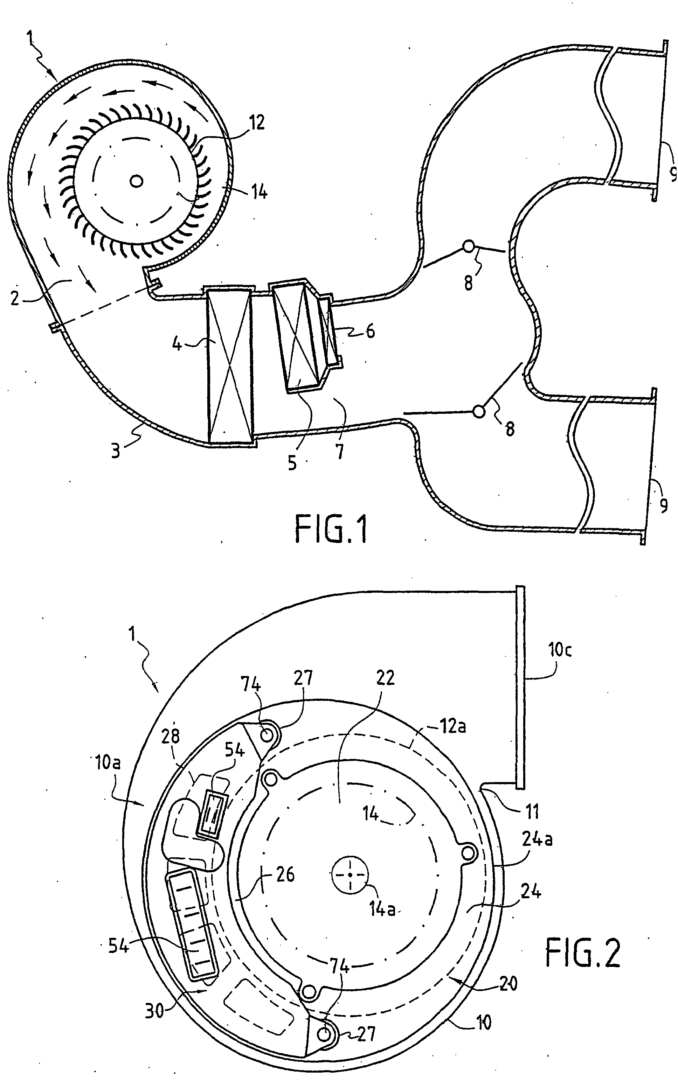

La figure 1 montre très schématiquement une partie d'une installation de chauffage et climatisation d'air de véhicule automobile qui comporte, de façon bien connue, un groupe moto-ventilateur 1, ou soufflante, délivrant un flux d'air 2 dans un boîtier de distribution et de traitement d'air 3.

Le canal du boîtier de distribution d'air 3 amène ce flux d'air 2 sous pression à travers un évaporateur 4 d'un circuit de réfrigération (lorsque la fonction climatisation d'air est présente), un radiateur échangeur thermique à liquide 5 parcouru par le liquide de refroidissement du moteur du véhicule et un radiateur électrique d'appoint éventuel 6. En mode climatisation, l'air est dévié par des volets (non représentés) dans un passage 7 en dérivation du radiateur 5. En aval des radiateurs 5 et 6, les conduits du boîtier 3 distribuent l'air sélectivement selon les positions de volets de mixage et distribution 8 vers des bouches de sorties 9 dans l'habitacle du véhicule.

Le groupe moto-ventilateur 1 comporte (figures 1 et 2) un boîtier de volute 10 à l'intérieur duquel est logée une turbine 12. Sur un de ses côtés 10a, le boîtier de volute 10 présente une ouverture fermée par un capot 20 formant support moteur 14 d'entraînement de la turbine 12. Le moteur 14 (montré schématiquement en trait mixte sur les figures 1 et 2) et la turbine 12 sont coaxiaux. La turbine 12 est montée par des bras radiaux sur l'arbre 14a de sortie du moteur 14. Le capot 20 support moteur délimite un logement 22 pour le moteur qui fait saillie latéralement sur le côté 10a du boîtier de volute 10. Le côté du boîtier de volute opposé au côté 10a présente une ouverture centrale d'admission d'air. L'air aspiré et mis en circulation par la turbine 12 est extrait du boîtier de volute 10 par une sortie 10c raccordée au conduit du boîtier de distribution d'air 3.

Un module de commande 30 de moteur, qui permet d'entraîner le moteur 14 à une vitesse de rotation variable en fonction du débit d'air désiré en sortie du boîtier de volute 10, est monté sur le capot support moteur 20. Plus précisément, le module 30 est monté sur une partie 26 d'un rebord 24 du capot support moteur 20 qui entoure le logement 22 moteur. Le rebord 24 a un contour 24a circulaire qui s'adapte à l'ouverture circulaire 13 formée sur le premier côté 10a du boîtier de volute 10. Le module 30 est relié par des connecteurs 54 et conducteurs (non représentés) à une source de tension d'alimentation, à une unité de contrôle de l'installation de chauffage et climatisation, et au moteur.

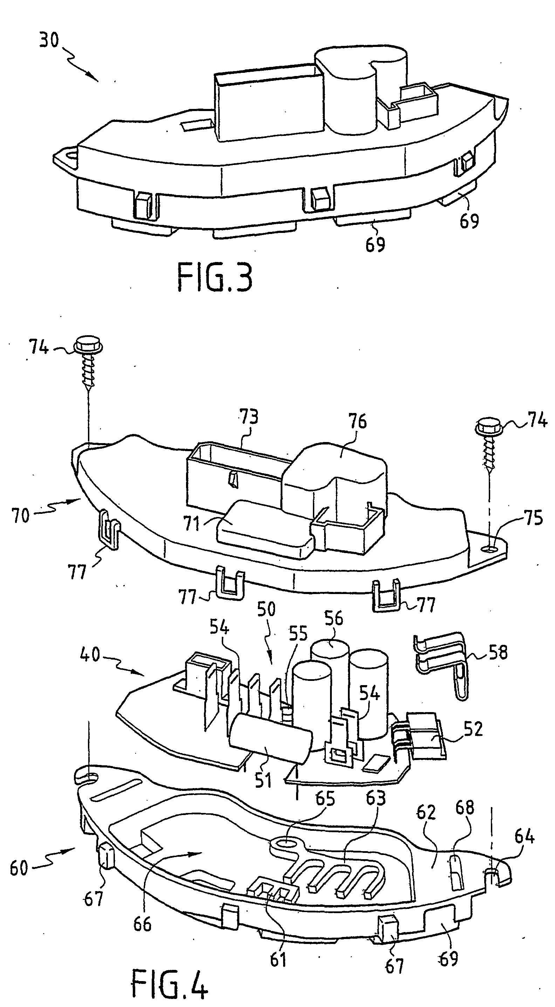

Dans le mode de réalisation de l'invention illustré par les figures 3 à 5, le module de commande 30 comporte une carte 40 de circuit imprimé sur laquelle sont disposés des composants électriques et électroniques 50 et des connecteurs 54 pour recevoir une tension d'alimentation et des signaux de commande de vitesse moteur et pour délivrer l'alimentation nécessaire au moteur 14. Les composants 50 et connecteurs 54 sont reliés entre eux par des pistes électriques. La carte 40 de circuit imprimé et les composants électroniques 50 sont en couplage thermique avec un radiateur 60 compact en une seule pièce.

Le radiateur 60 qui peut être en aluminium ou en tout autre alliage, s'étend sur toute la surface inférieure de la carte 40 et présente des premières zones de contact 61, 62 et des secondes zones de contact 63. Les premières zones de contact 61, 62 sont en contact thermique direct avec une pluralité de composants électroniques 51 et 52 et parmi elles au moins une zone 61 traverse la carte 40 de circuit imprimé pour épouser la forme d'au moins un composant électronique 51. Les secondes zones de contact 63 sont en contact thermique avec des zones équipotentielles sur la surface inférieure de la carte 40 de circuit imprimé.

Dans l'exemple de la figure 4, le radiateur 60 est sensiblement en forme de croissant délimitant un évidemment 66 destiné à accueillir la carte de circuit imprimé ayant une forme correspondant à celui-ci. Des remontées de matière ou reliefs 61 et 63 situées en regard des points les plus chauds de la carte sont formées dans l'évidemment. Ainsi, par exemple, la remontée de matière 61 en forme de E traverse la carte 40 de circuit imprimé pour se mettre en contact avec un self en épousant une partie de sa forme cylindrique. Tandis que, la remontée de matière 63 en forme de ligne est en contact thermique avec des zones équipotentielles sur la surface inférieure de la carte 40 en regard des condensateurs 56.

Le rebord du radiateur 60 présente une zone de contact 62 pour au moins un composant électronique 52 connecté à la carte 40 de circuit imprimé. Par exemple, des transistors de puissance 52 situés à l'extérieur d'un bord de la carte 40 sont en contact thermique sur toutes leurs surfaces inférieures avec une zone plane 62 du rebord du radiateur 60. Pour améliorer le couplage thermique entre les transistors de puissance 52 et le radiateur 60, une pince 58 engagée dans une lumière 68 située sur le rebord du radiateur 60, exerce une pression de contact sur les transistors 52 contre la zone de contact 62.

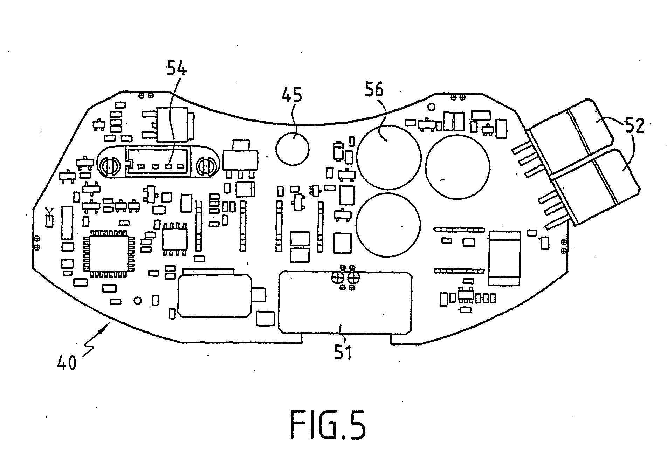

La carte de circuit imprimé illustrée sur la figure 5, présente une architecture compacte entre les composants électriques et électroniques. Ainsi, la longueur des pistes électriques (non représentées) reliant les différents composants est optimale de manière à définir une résistance totale inférieure à environ 2mΩ. Par conséquent, la perte par effet joule due à la conduction électrique est limitée à une valeur acceptable par les technologies courantes de circuits imprimés actuels.

Par ailleurs, le module de commande 30 est muni d'un capot 70 qui peut être en matière synthétique et qui recouvre la carte 40 de circuit imprimé et les composants portés par celle-ci. Par exemple le self 51, les connecteurs 54 et les condensateurs 56 sont logés dans des logements 71, 73 et 76 respectivement de formes correspondantes. Le capot 70 est fixé sur le radiateur 60 par des clips 77 qui s'engagent avec pression dans des ergots 67 correspondants situés sur la paroi latérale du radiateur 60. Par conséquent, en plus d'une protection mécanique de la carte et des composants contre des chocs ou la poussière, le capot assure une pression de contact de la carte 40 de circuit imprimé contre le radiateur 60, améliorant ainsi le couplage thermique entre la carte et celui-ci.

Avantageusement, le montage de la carte 40 sur le radiateur 60 est assuré par une vis unique 55 qui traverse la carte pour se loger dans un plot de fixation 65 situé dans l'évidemment 66 du radiateur 60.

Le radiateur 60 comporte des parties en saillie 69 telles que des ailettes à sa face inférieure. Les ailettes sont engagées (figure 2) dans des ouvertures 28 de la partie 26 du rebord 24 du capot moteur 20 sur lequel le module 30 est fixé.

Le module de commande 30 est fixé par exemple au moyen de vis 74 qui passent dans des pattes 64 aux extrémités du module et se vissent dans des plots 27 formés intégralement avec le capot support moteur 20 (figure 2).

Bien entendu, les formes globales ou les matières du radiateur et du capot, le nombre ou type de composants à refroidir pourront varier sans sortir du cadre de l'invention.

La forme compacte du radiateur favorise l'intégration du module de commande au plus près du moteur ou de l'organe à piloter et permet de supprimer les perturbations d'écoulement et du bruit, ainsi que le coût global d'un groupe moto-ventilateur.

Le meilleur refroidissement des composants électroniques améliore leur fiabilité dans le temps et permet de piloter des charges plus puissantes, correspondant aux besoins croissants de performances des installations de chauffage et/ou climatisation pour véhicule automobile. Grâce à un meilleur refroidissement selon l'invention, les composants peuvent fonctionner à une intensité de courant allant jusqu'à environ 30A et une température ambiante de l'air environnant allant jusqu'à environ 65°C.

Le contact de la carte du circuit imprimé sur le radiateur par le capot permet de supprimer des vis de fixation entre ces deux pièces et de réduire le temps de montage et le coût du module de commande.

## Revendications

1. Module de commande (30) de vitesse d'un moteur (14) de groupe moto-ventilateur (1) comportant une carte (40) de circuit imprimé sur laquelle sont disposés des composants électroniques (50) reliés entre eux par des pistes électriques, les composants électroniques (50) étant en couplage thermique avec un radiateur (60), **caractérisé en ce que** le radiateur (60) est en une seule pièce, s'étend sur toute la surface inférieure de la carte (40) et présente des premières zones de contact (61, 62) en contact thermique direct avec une pluralité de composants électroniques (51, 52) et des secondes zones de contact (63) en contact thermique avec des zones équipotentielles sur la surface inférieure de la carte (40) de circuit imprimé.

2. Module de commande (30) selon la revendication 1, **caractérisé en ce que** les pistes électriques transportant le courant destiné à alimenter le moteur (14) présentent une résistance totale inférieure à environ 2 mΩ.

3. Module de commande (30) selon la revendication 1 ou la revendication 2, **caractérisé en ce que** les premières zones de contact (61, 62) du radiateur (60) présentent au moins une remontée de matière (61) traversant la carte (40) de circuit imprimé pour épouser la forme d'au moins un composant électronique (51).

4. Module de commande (30) selon l'une quelconque des revendications 1 à 3, **caractérisé en ce que** les premières zones de contact (61, 62) présentent au moins une zone de contact (62) épousant la forme d'au moins un composant électronique (52) connecté à la carte (40) de circuit imprimé et situé à l'extérieur d'un bord de ladite carte (40).

5. Module de commande (30) selon la revendication 4, **caractérisé en ce qu'**il comporte en outre, une pince (58) destinée à assurer une pression de contact contre le radiateur (60) dudit composant électronique (52) situé à l'extérieur de la carte (40) de circuit imprimé.

6. Module de commande (30) selon l'une quelconque des revendications 1 à 5, **caractérisé en ce qu'**il comporte en outre un capot (70) fixé sur le radiateur (60) de façon à assurer une pression de contact de la carte (40) de circuit imprimé contre le radiateur (60).

7. Module de commande (30) selon la revendication 6, **caractérisé en ce que** le capot (70) est en matière synthétique.

8. Module de commande (30) selon l'une quelconque des revendications 1 à 7, **caractérisé en ce que** le radiateur (60) est en aluminium.

9. Module de commande selon l'une quelconque des revendications 1 à 8, **caractérisé en ce qu'**il comporte en outre une vis unique destinée à fixer la carte de circuit imprimé sur le radiateur.

10. Installation de chauffage et/ou climatisation pour véhicule automobile, comportant un groupe moto-ventilateur muni d'un module de commande selon l'une quelconque des revendications 1 à 9.

## Patentansprüche

1. Modul zur Steuerung (30) der Geschwindigkeit eines Motors (14) der Motorventilator-Gruppe (1) mit einer Leiterkarte (40), auf der elektronische Komponenten (50) angeordnet sind, die durch elektrische Pisten miteinander verbunden sind, wobei die elektronischen Komponenten (50) thermisch mit einem Kühler (60) verkoppelt sind, **dadurch gekennzeichnet, dass** der Kühler (60) aus einem einzigen Teil besteht, sich über die gesamte untere Fläche der Karte (40) erstreckt und über erste Kontaktzonen (61, 62) verfügt, die sich im direkten thermischen Kontakt mit mehreren elektronischen Komponenten (51, 52) befinden und über zweite Kontaktzonen (63), die sich im thermischen Kontakt mit äquipotentiellen Zonen an der unteren Fläche der Leiterkarte (40) befinden.

2. Modul zur Steuerung (30) nach Anspruch 1, **dadurch gekennzeichnet, dass** die elektrischen Pisten, die den Strom befördern, der den Motor (14) versorgen soll, einen Gesamtwiderstand aufweisen, der unter etwa 2 mΩ liegt.

3. Modul zur Steuerung (30) nach Anspruch 1 oder 2, **dadurch gekennzeichnet, dass** die ersten Kontaktzonen (61, 62) des Kühlers (60) mindestens einen Materialaufstieg (61) aufweist, der die Leiterkarte (40) durchquert, um sicher der Form von mindestens einer elektronischen Komponente (51) anzupassen.

4. Modul zur Steuerung (30) nach einem der Ansprüche 1 bis 3, **dadurch gekennzeichnet, dass** die ersten Kontaktzonen (61, 62) mindestens eine Kontaktzone (62) aufweisen, die sich der Form von mindestens einer elektronischen Komponente (52) anpasst, die an die Leiterkarte (40) angeschlossen ist und die sich außerhalb einer Kante von ebendieser Karte (40) befindet.

5. Modul zur Steuerung (30) nach Anspruch 4, **dadurch gekennzeichnet, dass** es ferner über eine Klemme (58) verfügt, die dazu dient, für einen Kontaktdruck gegen den Kühler (60) von der besagten elektronischen Komponente (52) zu sorgen, die sich außerhalb der Leiterkarte (40) befindet.

6. Modul zur Steuerung (30) nach einem der Ansprüche 1 bis 5, **dadurch gekennzeichnet, dass** es ferner über eine Haube (70) verfügt, die derart auf dem Kühler (60) befestigt ist, dass sie für einen Kontaktdruck von der Leiterkarte (40) gegen den Kühler (60) sorgt.

7. Modul zur Steuerung (30) nach Anspruch 6, **dadurch gekennzeichnet, dass** die Haube (70) aus synthetischem Material ist.

8. Modul zur Steuerung (30) nach einem der Ansprüche 1 bis 7, **dadurch gekennzeichnet, dass** der Kühler (60) aus Aluminium ist.

9. Modul zur Steuerung (30) nach einem der Ansprüche 1 bis 8, **dadurch gekennzeichnet, dass** es ferner über eine Einzelschraube verfügt, die dazu dient, die Leiterkarte am Kühler zu befestigen.

10. Heiz- und/oder Klimaanlage für Kraftfahrzeuge mit einer Motorventilator-Gruppe, die mit einem Modul zur Steuerung nach einem der Ansprüche 1 bis 9 ausgerüstet ist.

## Claims

1. Speed control module (30) for a motor (14) of an engine fan (1) comprising a printed circuit card (40) on which electronic components (50) are arranged connected to each other through electrical tracks, the electronic components (50) being thermally coupled with a heat sink (60), **characterised in that** the heat sink (60) is made of a single piece and extends over the entire lower surface of the card (40) and has its first contact areas (61, 62) in direct thermal contact with several electronic components (51, 52) and second contact areas (63) in thermal contact with equipotential areas on the lower surface of the printed circuit card (40).

2. Control module (30) according to claim 1, **characterised in that** the electrical tracks carrying the current that will supply the motor (14) have a total resistance of less than about 2 mΩ.

3. Control module (30) according to claim 1 or claim 2, **characterised in that** the first contact areas (61, 62) of the heat sink (60) have at least one upstand of material (61) passing through the printed circuit card (40) matching the shape of at least one electronic component (51).

4. Control module (30) according to any one of claims 1 to 3, **characterised in that** the first contact areas (61, 62) have at least one contact area (62) matching the shape of at least one electronic component (52) connected to the printed circuit card (40) and located outside an edge of the said card (40).

5. Control module (30) according to claim 4, **characterised in that** it also comprises a clamp (58) designed to apply a contact pressure between the heat sink (60) of the said electronic component (52) located outside the printed circuit card (40).

6. Control module (30) according to any one of claims 1 to 5, **characterised in that** it also comprises a cover (70) fixed onto the heat sink (60) so as to apply a contact pressure between the printed circuit card (40) and the heat sink (60).

7. Control module (30) according to claim 6, **characterised in that** the cover (70) is made of a synthetic material.

8. Control module (30) according to any one of claims 1 to 7, **characterised in that** the heat sink (60) is made of aluminium.

9. Control module according to any one of claims 1 to 8, **characterised in that** it also comprises a single screw designed to fix the printed circuit card onto the heat sink.

10. Heating and / or air conditioning installation for an automobile vehicle, comprising an engine fan provided with a control module according to any one of claims 1 to 9.
